# EUROPEAN PATENT SPECIFICATION

(11) **EP 1 001 304 B1**
(45) Date of publication and mention of the grant of the patent: **17.01.2007**
(21) Application number: 99122503.8
(22) Date of filing: 11.11.1999
(51) Int. Cl.: G02F 1/13, H05K 3/36

(54) **Liquid crystal display**
Flüssigkristallanzeige
Dispositif d'affichage à cristaux liquides

(30) Priority: 12.11.1998 JP 32214498
(43) Date of publication of application: 17.05.2000
(73) Proprietor: MATSUSHITA ELECTRIC INDUSTRIAL CO., LTD., Kadoma-shi, Osaka 571-0000 (JP)
(72) Inventor: Terao, Shinichi, Tokyo (JP); Kitamura, Toshiyasu, Yokohama-shi, Kanagawa (JP); Masutani, Yutaka, Yokohama-shi, Kanagawa (JP); Furukawa, Katsuhisa, Fujisawa-shi, Kanagawa (JP)
(74) Representative: Grünecker, Kinkeldey, Stockmair & Schwanhäusser Anwaltssozietät

(56) References cited:
- EP-A- 0 310 889
- EP-A- 0 981 183
- US-A- 4 695 258
- US-A- 5 358 412
- US-A- 5 400 160
- PATENT ABSTRACTS OF JAPAN vol. 1998, no. 04, 31 March 1998 (1998-03-31) & JP 09 318967 A (SEIKO EPSON CORP), 12 December 1997 (1997-12-12) -& US 6 025 644 A 15 February 2000 (2000-02-15)

## Description

### BACKGROUND OF THE INVENTION

The present invention relates to a liquid crystal display and a portable telephone comprising a liquid crystal display, and particularly, to a structure for attaching and connecting a liquid crystal display unit which is configured so that, when connection terminals formed on a flexible circuit board are to be connected to a printed circuit board through an embedded-conductor elastic member, a corrugated elastic member is interposed between a holding member and the flexible circuit board, thereby enabling the attachment and the connection to be uniformly attached and conducted.

A conventional liquid crystal display unit is disclosed in, for example, Japanese Patent Publication (Kokai) No. HEI9-288278. As shown in Figs. 4 and 5, in the conventional liquid crystal display device, a backlight 3 is placed on the back face of a liquid crystal display unit 1. The back light serves as a light guiding member 4 for guiding light emitted from a light emitting element 5 to illuminate the liquid crystal display unit 1 from the back side. A flexible circuit board 2 connected to the liquid crystal display unit 1 which is electrically connected to transparent electrodes via a conductive adhesive agent 7 is bent into a U-like shape. These components are fixed together by interposing members 6. Connection terminals 8 formed on the flexible circuit board 2 are drawn out to the back face and the outside of the back light 3 to be attached and connected to a connection member such as a connector which is not shown.

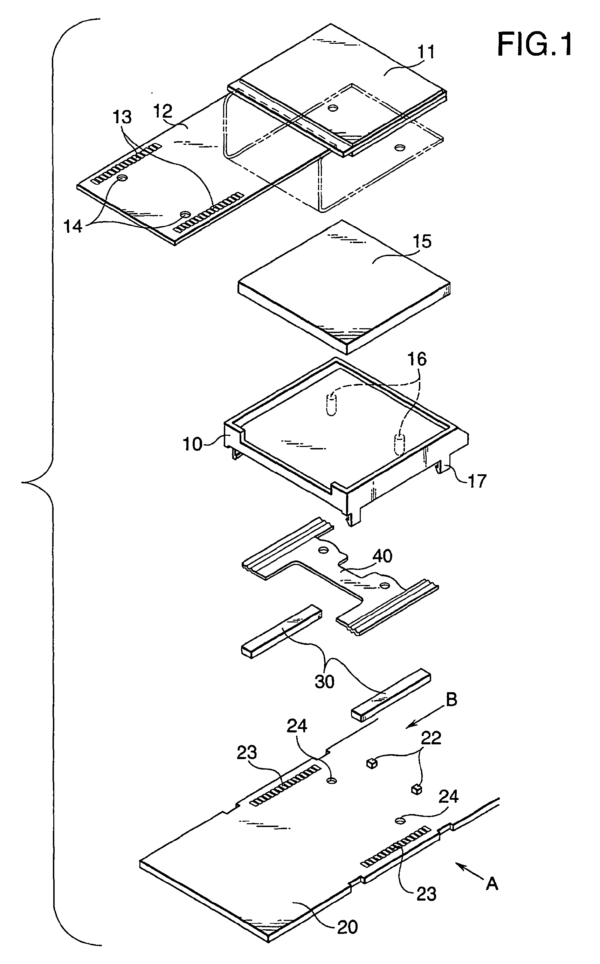

As described above, the conventional liquid crystal display device is configured so that the back light 3 and the flexible circuit board 2 are fixed to each other by the interposing members 6. Therefore, work for carrying out this fixation is required, thereby producing a problem in that the production cost is increased. Furthermore, the connection terminals 8 formed on the flexible circuit board 2 are once drawn out to the outside and then attached and connected there to a connector or the like. This produces another problem in attachment and connection, since the connection terminals 8 and the connector to be connected thereto must be prepared.
US-A-5, 358, 412 describes a liquid crystal display device that uses of a so-called "Zebra-strip", which connects the contacts of a printed circuit board with the corresponding connecting lines on a liquid crystal module. This "Zebra-strip" is an elastic member with embedded contact areas for the connection of aligned contacts areas of boards laid on its bottom and top surfaces, here of the printed circuit board and the LCD-module. A flexible circuit strip is used to connect different contacts of the printed circuit board to external power supply lines and sensors. The features of the preamble of claim 1 are known from US-A-5,358,412.
EP 0 981 183 A2 (prior art according to Art 54(3) EPC for DE, FR, GB) discloses a liquid crystal display device similar to the embodiment disclosed here, and recited in claim 1. However, the device of EPO 981 183 does not include a light emitting element on the printed circuit board (a light source 46 being accommodated in a holding member 40 : see figure 1) and is not provided with positioning bosses in the holding member.

### SUMMARY OF THE INVENTION

In order to solve the above problems, it is an object of the invention to provide a display device which is economical and has high connection reliability. This object is solved by the subject matter of the claims.

### SUMMARY OF THE INVENTION

Fig. 1 is a view showing the configuration of a liquid crystal display device;
Fig. 2 is a section view of the liquid crystal display device of Fig. 1, and taken along the direction A;
Fig. 3 is a section view of liquid crystal display device of Fig. 1, and taken along the direction B;

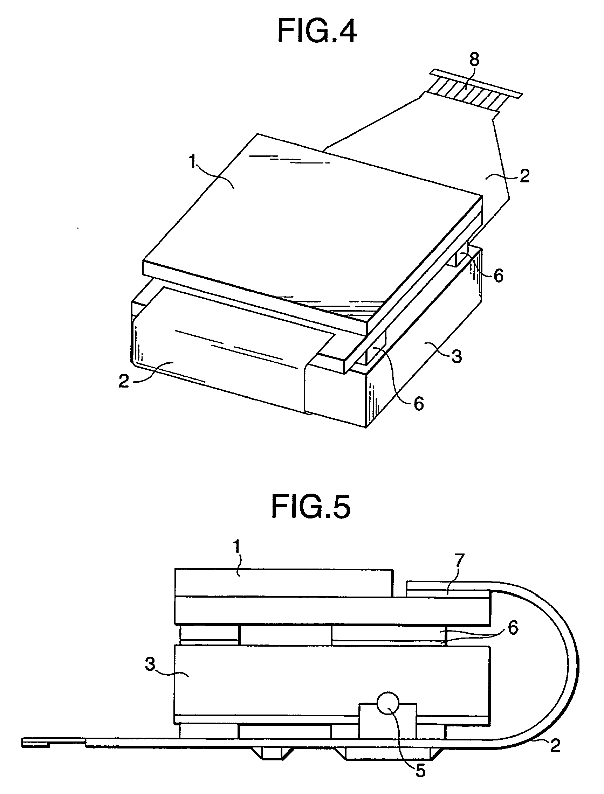

Fig. 4 is a perspective view of a conventional liquid crystal display device;
Fig. 5 is a side section view of the conventional liquid crystal display.

### DETAILED DESCRIPTION OF THE EMBODIMENT

Hereinafter, an embodiment of the invention will be described with reference to Figs. 1 to 3. The liquid crystal display device shown in Fig. 1 comprises:
a holding member 10 to which a liquid crystal display unit 11, a flexible circuit board 12, and
a light guiding plate 15 are attached and held; a printed circuit board 20 having light emitting elements (LED chips) 22 and exposed contact portions 23; embedded-conductor elastic members 30; and a corrugated elastic member 40.

In the vicinity of the tip end of the flexible circuit board 12, contact portions 13 and positioning holes 14 are formed. In the holding member 10, hooks 17 are disposed in a bottom portion, and positioning bosses 16 are disposed on the rear face.

Next, the operation of attaching and connecting the liquid crystal display device of the embodiment of the invention will be described. Referring to Fig. 1, first, the light guiding plate 15 is placed on the surface of the holding members 10. Next, the liquid crystal display unit 11 to which the flexible circuit board 12 is attached is placed on the holding member 10. The flexible circuit board is previously connected to transparent electrodes of a liquid crystal display element by a conductive adhesive agent or the like.

In this placement, a tip end portion of the flexible circuit board 12 is projected from a portion of a side face of the holding member 10 where an opening is set so as to correspond to the width (short side) of the flexible circuit board 12. The flexible circuit board is bent back to the rear side into a substantially U-like shape.

The corrugated elastic member 40 is previously placed on the rear face of the holding member 10. The tip end portion of the flexible circuit board 12 is placed below the corrugated elastic member 40, and then fixed by passing the positioning bosses 16 on the rear side of the holding member through the positioning holes 14 disposed in the tip end of the flexible circuit board 12. Therefore, the contact portions 13 disposed on the tip end of the flexible circuit board 12 are opposed to the exposed contact portions 23 of the printed circuit board 20.

The contact portions 13 disposed on the flexible circuit board 12 are arranged evenly in a lateral direction along portions of the two long sides of the flexible circuit board, and the exposed contact portions 23 of the printed circuit board 20 are arranged evenly in a lateral direction along the long sides of the printed circuit board 20.

Next, the embedded-conductor elastic members 30 also are arranged evenly in a lateral direction on the exposed contact portions 23 of the printed circuit board 20. The hooks 17 of the holding member 10 into which the liquid crystal display unit 11 and the and the other parts are accommodated as described above are engaged with recesses which are formed in predetermined positions of the printed circuit board 20, i.e., along the long sides of the printed circuit board 20. The positioning bosses 16 of the holding member 10 are passed through positioning holes 24 which are formed along the short side of the printed circuit board 20.

As a result, the contact portions 13 disposed on the tip end of the flexible circuit board 12 that is bent back to the rear side of the holding member 10 into which the liquid crystal display unit 11 and the other parts are incorporated and held, and the exposed contact portions 23 of the printed circuit board 20 are urged by the elastic force of the corrugated elastic member 40. The elastic force of the corrugated elastic member 40 is varied only by applying a force to the member to change the wave height, and hence has the property of applying the elastic force evenly in a predetermined range.

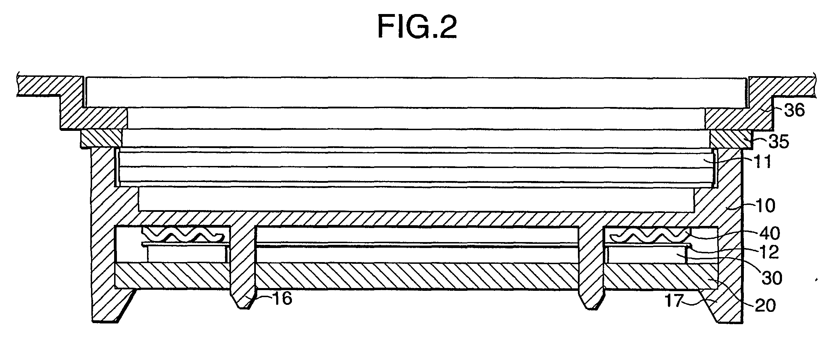

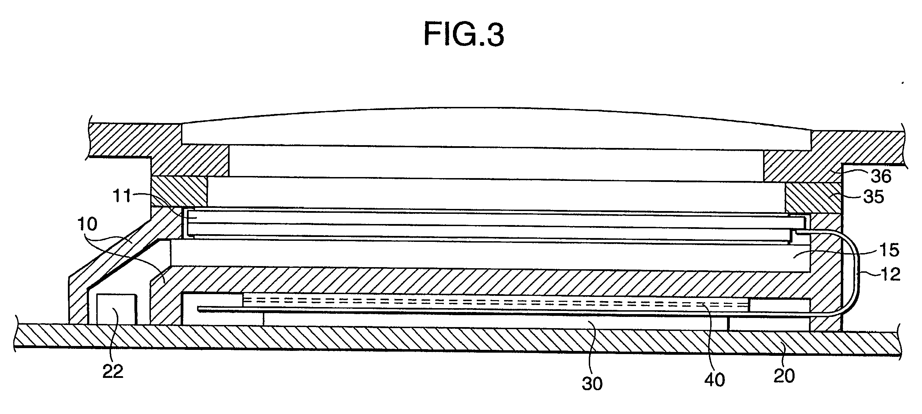

Figs. 2 and 3 shows the liquid crystal display device which is attached and connected as described above. Fig. 2 is a section view of the liquid crystal display unit of Fig. 1, and taken along the direction A.

As seen from Fig. 2, the corrugated elastic member 40 is interposed between the holding member 10 and the flexible circuit board 12, the bosses 16 of the holding member 10 are passed through the positioning holes of the printed circuit board 20, the hooks 17 are engaged with the predetermined positions of the printed circuit board 20, and the connection terminals formed on the flexible circuit board are attached and connected to the printed circuit board through the embedded-conductor elastic members 30.

In the liquid crystal display unit shown in Fig. 2, actually, a glass plate and the transparent electrodes are arranged across the LCD (liquid crystal display) element. This assembly is placed on the light guiding plate 15, and below a transparent plate which is placed on a cover 36 via a cushion 35 that is disposed on the periphery of the holding member 10.

Fig. 3 is a section view of the device for attaching and connecting a liquid crystal display unit of Fig. 1, and taken along the direction B. As seen from Fig. 3, the light emitting elements (LED chips) 22 disposed on the printed circuit board 20 are housed in the holding member 10, and light emitted from the light emitting elements (LED chips) 22 is guided to the light guiding plate 15 via a reflecting surface formed on the holding member 10.

Furthermore, the manner will be seen in which the contact portions 13 disposed in the tip end of the flexible circuit board 12 are contacted and connected to the embedded-conductor elastic members 30 placed on the exposed contact portions 23 of the printed circuit board 20, by an adequate pressure exerted by the elastic force of the corrugated elastic member 40.

In the same manner as Fig. 2, in Fig. 3 also, actually, the liquid crystal display unit is configured so that the glass plate and the transparent electrodes are arranged across the LCD (liquid crystal display) element. This assembly is placed on the light guiding plate 15, and below the transparent plate which is placed on the cover 36 via the cushion 35 that is disposed on the periphery of the holding member 10.

In Figs. 1 to 3, it is not shown that a control LSI for the liquid crystal display unit is mounted on the flexible circuit board 12. The mounting of such a control LSI is known in the fields of a TAB (Tape-Automated-Bonding), etc. Therefore, the LSI is not shown in the figures.

## Claims (Claims for the following Contracting State(s): SE)

1. A liquid crystal display device, comprising:
a liquid crystal display unit (11);
a holding member (10) having a first and a second face and arranged to accommodate the liquid crystal display unit (11) on the first face and provided with hooks (17);
an elastic member (40) placed on the second face of the holding member (10);
a flexible circuit board (12) provided with contact portions (13) formed along portions of the two long sides of the flexible circuit board in the vicinity of one end,
the elastic member (40) being interposed between the holding member (10) and the flexible circuit board (12) to press on the flexible circuit board (12);
a printed circuit board (20) facing the second face of the holding member (10) and
engaged by the holding member (10) by means of said
hooks (17), provided with contact portions (23) corresponding to the contact portions (13) on the flexible circuit board (12) and to be electrically connected to them;
embedded-conductor elastic members (30) placed on the printed circuit board (20);
**characterised in that**
the elastic member (40) is corrugated, the flexible circuit board (12) is connected to the liquid crystal display unit (11) at the end opposite to the end provided with contact portions (13) and is bent in a U-like shape, so as to enclose the holding member (10), such that the embedded-conductor elastic members (30) are placed between the flexible circuit board (12) and the printed circuit board (20), so as to electrically connect the contact portions (23) on the printed circuit board (20) with the contact portions (13) of the flexible circuit board (12).

2. A liquid crystal display device according to claim 1, further comprising positioning bosses (16) provided on the holding member (10) and inserted into positioning holes provided in the flexible circuit board (12), the printed circuit board (20) and the corrugated elastic member (40).

3. A liquid crystal display device according to claim 1 or 2, further comprising a light emitting element (22) arranged on the printed circuit board (20).

4. A liquid crystal display device according to any of claims 1 - 3, wherein the holding member (10) encompasses a light guiding plate (15) being arranged beneath the liquid crystal display unit (11).

5. A liquid crystal display device according to any of claims 1 - 4, wherein there is provided a reflective surface on the holding member (10) to guide the light from the light emitting element to the light guiding plate (15).

6. A liquid crystal display device according to any of claims 1 to 5, wherein the flexible circuit board (12) is electrically connected to the transparent electrodes of the liquid crystal display unit (11) via a conductive adhesive agent.

7. A portable telephone comprising a liquid crystal display device according to any of claims 1 to 6.

## Claims (Claims for the following Contracting State(s): DE, FR, GB)

1. A liquid crystal display device, comprising:
a liquid crystal display unit (11);
a holding member (10) having a first and a second face and arranged to accommodate the liquid crystal display unit (11) on the first face and provided with hooks (17);
an elastic member (40) placed on the second face of the holding member (10);
a flexible circuit board (12) provided with contact portions (13) formed along portions of the two long sides of the flexible circuit board in the vicinity of one end,
the elastic member (40) being interposed between the holding member (10) and the flexible circuit board (12) to press on the flexible circuit board (12);
a printed circuit board (20) facing the second face of the holding member (10) and
engaged by the holding member (10) by means of said
hooks (17), provided with contact portions (23) corresponding to the contact portions (13) on the flexible circuit board (12) and to be electrically connected to them;
embedded-conductor elastic members (30) placed on the printed circuit board (20);
**characterised in that**
the elastic member (40) is corrugated, the flexible circuit board (12) is connected to the liquid crystal display unit (11) at the end opposite to the end provided with contact portions (13) and is bent in a U-like shape, so as to enclose the holding member (10), such that the embedded-conductor elastic members (30) are placed between the flexible circuit board (12) and the printed circuit board (20), so as to electrically connect the contact portions (23) on the printed circuit board (20) with the contact portions (13) of the flexible circuit board (12);
and wherein
positioning bosses (16) provided on the holding member (10) and inserted into positioning holes provided in the flexible circuit board (12), the printed circuit board (20) and the corrugated elastic member (40), and
a light emitting element (22) arranged on the printed circuit board (20).

2. A liquid crystal display device according to claim 1, wherein the holding member (10) encompasses a light guiding plate (15) being arranged beneath the liquid crystal display unit (11).

3. A liquid crystal display device according to claim 1 or 2, wherein there is provided a reflective surface on the holding member (10) to guide the light from the light emitting element to the light guiding plate (15).

4. A liquid crystal display device according to any of claims 1 to 3, wherein the flexible circuit board (12) is electrically connected to the transparent electrodes of the liquid crystal display unit (11) via a conductive adhesive agent.

5. A portable telephone comprising a liquid crystal display device according to any of claims 1 to 4.

## Patentansprüche

1. Flüssigkristall-Anzeigevorrichtung, die umfasst:
eine Flüssigkristall-Anzeigeeinheit (11);
ein Halteelement (10), das eine erste und eine zweite Fläche hat und so eingerichtet ist, dass es die Flüssigkristall-Anzeigeeinheit (11) an der ersten Fläche aufnimmt, und mit Haken (17) versehen ist;
ein elastisches Element (40), das an der zweiten Fläche des Halteelementes (10) angeordnet ist;
eine flexible Leiterplatte (12), die mit Kontaktabschnitten (13) versehen ist, die an Abschnitten der zwei langen Seiten der flexiblen Leiterplatte in der Nähe eines Endes ausgebildet sind,
wobei das elastische Element (40) zwischen dem Halteelement (10) und der flexiblen Leiterplatte (12) angeordnet ist, um auf die flexible Leiterplatte (12) zu drücken;
eine Leiterplatte (20), die der zweiten Fläche des Halteelementes (10) zugewandt ist, mittels der Haken (17) mit dem Halteelement (10) in Eingriff ist und mit Kontaktabschnitten (23) versehen ist, die den Kontaktabschnitten (13) an der flexiblen Leiterplatte (12) entsprechen und elektrisch mit ihnen zu verbinden sind;
elastische Elemente (30) mit eingebetteten Leitern, die auf der Leiterplatte (20) angeordnet sind;
**dadurch gekennzeichnet, dass**:
das elastische Element (40) gewellt ist, die flexible Leiterplatte (12) mit der Flüssigkristall-Anzeigeeinheit (11) an dem Ende gegenüber dem Ende verbunden ist, das mit Kontaktabschnitten (13) versehen ist, und in einer U-artigen Form gebogen ist, um das Halteelement (10) zu umschließen, so dass die elastischen Elemente (30) mit eingebetteten Leitern zwischen der flexiblen Leiterplatte (12) und der Leiterplatte (20) angeordnet sind, um so die Kontaktabschnitte (23) an der Leiterplatte mit den Kontaktabschnitten (13) der flexiblen Leiterplatte (12) elektrisch zu verbinden;
und wobei Positioniervorsprünge (16) an dem Halteelement (10) vorhanden und in Positionierlöcher eingeführt sind, die in der flexiblen Leiterplatte (12), der Leiterplatte (20) und dem gewellten elastischen Element (40) vorhanden sind, und
ein lichtemittierendes Element (22) an der Leiterplatte (20) angeordnet ist.

2. Flüssigkristall-Anzeigevorrichtung nach Anspruch 1, wobei das Halteelement (10) eine Lichtleitplatte (15) einschließt, die unter der Flüssigkristall-Anzeigeeinheit (11) angeordnet ist.

3. Flüssigkristall-Anzeigevorrichtung nach Anspruch 1 oder 2, wobei eine reflektierende Fläche an dem Halteelement (10) vorhanden ist, um das Licht von dem lichtemittierenden Element zu der Lichtleitplatte (15) zu leiten.

4. Flüssigkristall-Anzeigevorrichtung nach einem der Ansprüche 1 bis 3, wobei die flexible Leiterplatte (12) über einen leitenden Klebstoff elektrisch mit den transparenten Elektroden der Flüssigkristall-Anzeigeeinheit (11) verbunden ist.

5. Tragbares Telefon, das eine Flüssigkristall-Anzeigevorrichtung nach einem der Ansprüche 1 bis 4 umfasst.

## Revendications

1. Dispositif d'affichage à cristaux liquides comprenant :
une unité d'affichage à cristaux liquides (11) ;
un organe de maintien (10) ayant une première et une deuxième face et agencé pour accueillir l'unité d'affichage à cristaux liquides (11) sur la première face et équipé d'accroches (17) ;
un organe élastique (40) placé sur la deuxième face de l'organe de maintien (10) ;
une carte de circuit flexible (12) équipée de portions de contact (13) formées le long de portions des deux longs côtés de la carte de circuit flexible dans la proximité d'une extrémité,
l'organe élastique (40) étant intercalé entre l'organe de maintien (10) et la carte de circuit flexible (12) afin d'appuyer sur la carte de circuit flexible (12) ;
une carte de circuit imprimée (20) faisant face à la deuxième face de l'organe de maintien (10) et engagée par l'organe de maintien (10) au moyen desdites accroches (17), équipée de portions de contact (23) correspondant aux portions de contact (13) sur la carte de circuit flexible (12) et pour être connectées électriquement à celles-ci ;
des organes élastiques avec conducteur incorporé (30) placés sur la carte de circuit imprimée (20) ;
**caractérisé en ce que**
l'organe élastique (40) est ondulé, la carte de circuit flexible (12) est connectée à l'unité d'affichage à cristaux liquides (11) à l'extrémité opposée à l'extrémité équipée de portions de contact (13) et est pliée en forme de U, de façon à enfermer l'organe de maintien (10), tel que les organes élastiques avec conducteur incorporé (30) sont placés entre la carte de circuit flexible (12) et la carte de circuit imprimée (20), de façon à connecter électriquement les portions de contact (23) sur la carte de circuit imprimée (20) avec les portions de contact (13) de la carte de circuit flexible (12) ;
et dans lequel des bosses de positionnement (16) pourvues sur l'organe de maintien (10) et insérées dans des trous de positionnement pourvus dans la carte de circuit flexible (12), la carte de circuit imprimée (20) et l'organe élastique ondulé (40), et
un élément émetteur de lumière (22) agencé sur la carte de circuit imprimée (20).

2. Dispositif d'affichage à cristaux liquides selon la revendication 1, dans lequel l'organe de maintien (10) inclut une plaque de guidage de lumière (15) étant agencée en dessous de l'unité d'affichage à cristaux liquides (11).

3. Dispositif d'affichage à cristaux liquides selon la revendication 1 ou 2, dans lequel est fournie une surface réfléchissante sur l'organe de maintien (10) pour guider la lumière depuis l'élément émetteur de lumière vers la plaque de guidage de lumière (15).

4. Dispositif d'affichage à cristaux liquides selon l'une quelconque des revendications 1 à 3, dans lequel la carte de circuit flexible (12) est connectée électriquement aux électrodes transparentes de l'unité d'affichage à cristaux liquides (11) par un agent adhésif conducteur.

5. Téléphone portable comprenant un dispositif d'affichage à cristaux liquides selon l'une quelconque des revendications 1 à 4.
